(19) Europäisches Patentamt
European Patent Office
Office européen des brevets

(11) **EP 1 366 459 B1**

(12) **EUROPÄISCHE PATENTSCHRIFT**

(45) Veröffentlichungstag und Bekanntmachung des Hinweises auf die Patenterteilung:
**03.05.2006 Patentblatt 2006/18**

(21) Anmeldenummer: 02717977.9

(22) Anmeldetag: **26.02.2002**

(51) Int Cl.:
*G06K 9/00* (2006.01)      *H01L 27/02* (2006.01)

(86) Internationale Anmeldenummer:
**PCT/DE2002/000690**

(87) Internationale Veröffentlichungsnummer:
**WO 2002/071313 (12.09.2002 Gazette 2002/37)**

(54) **FINGERABDRUCKSENSOR MIT POTENTIALMODULATION DES ESD-SCHUTZGITTERS**

FINGERPRINT SENSOR WITH POTENTIAL MODULATION OF THE ESD PROTECTIVE SCREEN

DETECTEUR D'EMPREINTES DIGITALES A MODULATION DE POTENTIEL DE LA GRILLE DE PROTECTION CONTRE LES DECHARGES ELECTROSTATIQUES

(84) Benannte Vertragsstaaten:
**AT DE FR GB IT**

(30) Priorität: **06.03.2001 DE 10110724**

(43) Veröffentlichungstag der Anmeldung:
**03.12.2003 Patentblatt 2003/49**

(73) Patentinhaber: **Infineon Technologies AG**
**81669 München (DE)**

(72) Erfinder:
• **GRESCHITZ, Manfred**
**A-8045 Graz (AT)**
• **SCHEUCHER, Albert**
**A-8423 St. Veit/Vogau (AT)**
• **HIERZ, Gerhard**
**A-8043 Graz (AT)**
• **WOLF, Franz**
**A-8071 Grambach (AT)**

(74) Vertreter: **Graf Lambsdorff, Matthias**
**Patentanwälte**
**Lambsdorff & Lange**
**Dingolfinger Strasse 6**
**81673 München (DE)**

(56) Entgegenhaltungen:
**EP-A- 1 059 602       WO-A-00/10205**
**WO-A-00/42657       US-A- 6 069 970**

• **INGLIS D ET AL: "SA 17.7:A ROBUST, 1.8V 250MUW DIRECT-CONTACT 500DPI FINGERPRINT SENSOR" IEEE INTERNATIONAL SOLID STATE CIRCUITS CONFERENCE, IEEE INC. NEW YORK, US, 1998, Seiten 284-285, XP000856844 ISSN: 0193-6530**

**Beschreibung**

Die Erfindung bezieht sich generell auf Sensoren, welche zur Aufnahme von Fingerabdrücken verwendet werden. Insbesondere betrifft die Erfindung eine Vorrichtung zum ESD-Schutz (englisch: Electrostatic Discharge) für derartige Fingerabdrucksensoren.

Jede Person weist biologische Merkmale auf, deren Charakteristika von Geburt an unveränderlich sind und die sich der zugehörigen Person eindeutig zuordnen lassen. Eines dieser biologischen Merkmale sind die Fingerabdrücke. Fingerabdrücke weisen Muster ihrer Papillarlinien aus Bögen, Wirbeln und Schleifen auf. Die Charakteristika dieser Muster sind stets einzigartig. Daher werden bei Geräten, mit denen die Identität einer Person festgestellt werden soll, häufig die Charakteristika eines Fingerabdrucks zur Identifizierung der betreffenden Person herangezogen. Derartige Geräte können in vielfältiger Weise eingesetzt werden. Besonders im Bereich des E-Commerce, beim elektronischen Bankwesen oder bei Eingängen zu Gebäudebereichen sind auf der Erkennung von Fingerabdrücken basierende Sicherheitssysteme sinnvolle Einrichtungen, um vor Mißbrauch zu schützen.

Zur Aufnahme eines Fingerabdrucks werden meistens kapazitive Fingerabdrucksensoren eingesetzt. Solche Fingerabdrucksensoren weisen eine Kontaktoberfläche mit einer darunterliegenden Matrix aus vielen einzelnen Sensorelektroden auf. An die Sensorelektroden wird eine Wechselspannung angelegt. Sobald ein Finger in die Nähe der Matrix gebracht wird, entstehen elektrostatische Kapazitäten zwischen der Fingerunterseite und den mit der Wechselspannung beaufschlagten Sensorelektroden. Aufgrund der unterschiedlichen Dielektrizitätszahlen der Papillarlinien und der Rillen des Fingerabdrucks kann dabei zwischen den Papillarlinien und den Rillen unterschieden werden. Dieses ermöglicht eine zweidimensionale Darstellung des Fingerabdrucks. Derartige Fingerabdrucksensoren sind aus den Druckschriften JP 8 305 832 A und US 6 055 324 A1 bekannt. Insbesondere wird in diesen Druckschriften die Funktion der Wechselspannung, mit welcher die Sensorelektroden beaufschlagt werden, erläutert. Beide Druckschriften werden hiermit in den Offenbarungsgehalt der vorliegenden Patentanmeldung aufgenommen.

Bei Fingerabdrucksensoren ist es vorgesehen, daß der Finger, dessen Abdruck aufgenommen werden soll, direkt die Kontaktoberfläche des Fingerabdrucksensors berührt. Bei einer solchen Berührung des Fingers mit dem Fingerabdrucksensor kann es leicht zu einer elektrostatischen Aufladung kommen. Die anschließende Entladung oder die dadurch verursachten Überspannungen können zu einer Beeinträchtigung der Funktion oder gar zu einer Zerstörung des Fingerabdrucksensors führen. Zur Vermeidung der elektrostatischen Aufladung ist es im Normalgebrauch eines Fingerabdrucksensors nicht akzeptabel, wenn der Finger vor dem Kontakt mit dem Fingerabdrucksensor zur Entladung geerdet werden muß. Aus diesem Grund wird der ESD-Schutz des Fingerabdrucksensors häufig durch ein Wolfram-Schutzgitter, welches sich oberhalb der Sensorelektroden-Matrix befindet, gewährleistet. Beispielsweise ist diese Schutzmaßnahme in der Druckschrift DE 199 01 384 A1 beschrieben. Diese Druckschrift wird hiermit in den Offenbarungsgehalt der vorliegenden Patentanmeldung aufgenommen. Nachteilig an einem Wolfram-Schutzgitter ist, daß dadurch die Empfindlichkeit des Fingerabdrucksensors verringert wird, weil die elektrischen Feldlinien, die von den Sensorelektroden zur Kontaktoberfläche führen, teilweise durch das Wolfram-Schutzgitter abgelenkt werden. Die Empfindlichkeit E eines Fingerabdrucksensors ist durch folgende Gleichung definiert:

$$E = \frac{C_{Nutz}}{C_{Streu}}, \qquad\qquad (1)$$

wobei $C_{Nutz}$ für die Nutzkapazität zwischen den Sensorelektroden und dem Finger steht und $C_{Streu}$ die unerwünschte Streukapazität bezeichnet. Die Streukapazität $C_{Streu}$ umfaßt die Kapazität zwischen den Sensorelektroden und dem Schutzgitter.

Die Empfindlichkeit ist ein wesentliches Qualitätsmerkmal eines Fingerabdrucksensors. Nur durch eine ausreichende Empfindlichkeit lassen sich die vielseitigen Charakteristika eines Fingerabdrucks erfassen.

Ein Fingerabdrucksensor mit den Merkmalen des Oberbegriffs des Anspruchs 1 ist aus der US-Patentschrift US 6,069,970 A bekannt. Ein weiterer Fingerabdrucksensor, bei welchem ebenfalls eine ESD-Schutzelektrode zur Erhöhung der Sensorempfindlichkeit mit einer Wechselspannung beaufschlagt wird, ist aus der europäischen Offenlegungsschrift EP 1 059 602 A1 bekannt.

Aufgabe der Erfindung ist es daher, eine Vorrichtung zum ESD-Schutz für einen kapazitiven Fingerabdrucksensor zu schaffen, welche die Empfindlichkeit des Fingerabdrucksensors nicht wesentlich verringert.

Die der Erfindung zugrundeliegende Aufgabenstellung wird durch die Merkmale der unabhängigen Patentansprüche gelöst. Vorteilhafte Weiterbildungen und Ausgestaltungen sind in den Unteransprüchen angegeben.

Ein erfindungsgemäßer Fingerabdrucksensor weist eine Mehrzahl von Sensorelektroden auf, mit denen ein Fingerabdruck aufgenommen werden kann. Die Sensorelektroden sind unterhalb einer für den Kontakt mit der Fingerunterseite bestimmten Kontaktoberfläche des Fingerabdrucksensors angebracht. Des weiteren weist der Fingerabdrucksensor mindestens eine Schutzelektrode auf, welche sich entweder auf oder in der Kontaktoberfläche befinden kann und welche die Sensorelektroden zumindest nicht vollständig abdeckt. Die Funktion der mindestens einen Schutzelektrode ist es, den ESD-Schutz und den Überspannungsschutz des Fingerabdrucksensors zu gewährleisten. Die Sensorelektroden sind mit einer ersten Wechselspannung beaufschlagbar, wobei die erste Wechselspannung eine vorgegebene Frequenz aufweist. Die erste Wechselspannung erzeugt eine Spannung zwischen den Sensorelektroden und der Fingerunterseite, welche zum Auslesen der Kapazitäten, die von den Sensorelektroden und der Fingerunterseite verursacht werden, benötigt wird. Die mindestens eine Schutzelektrode ist mit einer zweiten Wechselspannung beaufschlagbar. Die zweite Wechselspannung weist im wesentlichen die vorgegebene Frequenz auf.

Experimente ergaben, daß durch Modulation der mindestens einen Schutzelektrode mit der zweiten Wechselspannung, welche im wesentlichen die Frequenz der ersten Wechselspannung aufweist, der Einfluß der mindestens einen Schutzelektrode auf die Empfindlichkeit des Fingerabdrucksensors verringert wird. Die Empfindlichkeit läßt sich beispielsweise durch eine Variation der Amplitude der zweiten Wechselspannung sogar so weit steigern, bis der Fingerabdrucksensor mit der mindestens einen Schutzelektrode die gleiche Empfindlichkeit aufweist, wie sie ein baugleicher Fingerabdrucksensor ohne eine Schutzelektrode aufweisen würde. Durch das Beaufschlagen der mindestens einen Schutzelektrode mit der zweiten Wechselspannung wird dem kapazitiven System aus Sensorelektroden und Finger zusätzliche Energie zugeführt, wodurch sich die Kompensation der Empfindlichkeitseinbuße erklären läßt. Diese Maßnahme führt zu dem gleichen Effekt, der durch eine Erhöhung des Verhältnisses aus Nutzkapazität und Streukapazität nach Gleichung (1) erzielt würde. Ein eventuell verbessertes Design einer dem Fingerabdrucksensor nachgeschalteten Auswerteschaltung, welches häufig zur Kompensation der Empfindlichkeitseinbuße durch einen ESD-Schutz benötigt wird, kann durch den erfindungsgemäßen Fingerabdrucksensor eingespart werden.

Erfindungsgemäß ist die Amplitude der zweiten Wechselspannung größer als die Versorgungsspannung, mittels welcher der Fingerabdrucksensor betrieben wird. Durch diese Maßnahme läßt sich eine größere Empfindlichkeit des Fingerabdrucksensors erzielen, als sie ohne ESD-Schutz möglich wäre.

Vorteilhafterweise ist die mindestens eine Schutzelektrode als gitter- oder rechen- oder streifenähnliche Fläche ausgebildet. Diese Maßnahme ermöglicht es, bei einer geeigneten Ausbildung der Schutzelektrode und einer geeigneten Anordnung der Sensorelektroden mit nur einer Schutzelektrode einen optimalen ESD-Schutz des Fingerabdrucksensors zu erzielen. Dazu muß gewährleistet sein, daß sich bei allen drei Ausgestaltungen Teile der mindestens einen Schutzelektrode in hinreichender Nähe zu den Sensorelektroden befinden.

Gemäß einer weiteren vorteilhaften Ausgestaltung der Erfindung sind die Amplituden der ersten und der zweiten Wechsels pannung einstellbar. Durch eine geeignete Variation der Amplitude der zweiten Wechselspannung wird die Empfindlichkeit des Fingerabdrucksensors erhöht. Insbesondere kann vorgesehen sein, daß die Amplitude der zweiten Wechselspannung größer als die Amplitude der ersten Wechselspannung ist.

Eine weitere vorteilhafte Ausgestaltung der Erfindung sieht vor, daß die Phasen der ersten und der zweiten Wechselspannung einstellbar sind. Experimente zeigten, daß bei einer geeigneten Differenz zwischen den Phasen der ersten und der zweiten Wechselspannung die Empfindlichkeit des Fingerabdrucksensors wesentlich erhöht werden kann.

Das erfindungsgemäße Verfahren gibt den notwendigen Schritt an, um die Empfindlichkeit eines kapazitiven Fingerabdrucksensors mit den oben beschriebenen Merkmalen, zu optimieren. Dazu wird die Amplitude und/oder die Phase der zweiten Wechselspannung derart eingestellt, daß die Empfindlichkeit des Fingerabdrucksensors einen maximalen Wert annimmt. Es wurde oben bereits erläutert, daß sich durch eine derartige Variation der Amplitude und/oder der Phase der zweiten Wechselspannung die Empfindlichkeit des Fingerabdrucksensors über die Empfindlichkeit eines Fingerabdrucksensors ohne Schutzelektrode steigern läßt. Bei dem erfindungsgemäßen Verfahren kann die Empfindlichkeit beispielsweise durch das lokale Auflösungsvermögen des Fingerabdrucksensors bestimmt werden. Dieses Verfahren stellt eine technisch sehr einfach zu realisierende Möglichkeit dar, um bei einem Fingerabdrucksensor mit ESD-Schutz die durch den ESD-Schutz verursachte Empfindlichkeitseinbuße zu kompensieren.

Ein Ausführungsbeispiel eines Fingerabdrucksensors wird nachfolgend in beispielhafter Weise unter Bezugnahme auf die Zeichnungen erläutert. Diese zeigen:

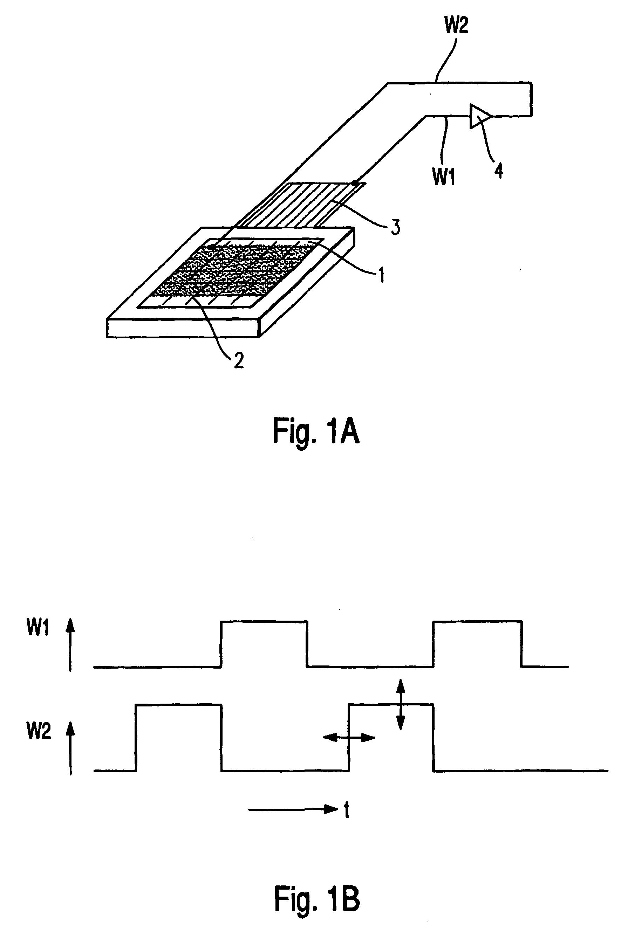

Fig. 1A    eine schematische Darstellung eines Ausführungsbeispiels eines Fingerabdrucksensors; und

Fig. 1B    eine schematische Darstellung der Amplituden- und Phasenvariation der zweiten Wechselspannung.

In Fig. 1A ist ein kapazitiver Fingerabdrucksensor 1 gezeigt, dessen eine Oberfläche zum Kontakt mit einer aufzunehmenden Fingerunterseite dient. Auf dieser Oberfläche ist ein Schutzgitter 2 zum ESD-Schutz angebracht. Ein Flachbandkabel 3 dient dazu, den Fingerabdrucksensor 1 zur Aufnahme des Fingerabdrucks mit einer Wechselspannung W1 und weiteren Signalen anzusteuern und gleichzeitig die von dem Fingerabdrucksensor 1 aufgenommenen Signale an eine nachgeschaltete Auswerteeinheit weiterzuleiten. Zusätzlich wird die Wechselspannung W1 mit dem internen Takt des Fingerabdrucksensors 1 durch eine Verzweigung aus dem Flachbandkabel 3 herausgeführt und einem regelbaren Verstärker 4 zugeführt. Am Verstärker 4 läßt sich die Amplitude und die Phase der von dem Verstärker 4 ausgegebenen Wechselspannung W2 einstellen. Die Frequenz der Wechselspannung W1 wird durch den Verstärker 4 nicht verändert. Mit der Wechselspannung W2 wird das auf dem Fingerabdrucksensor 1 angebrachte Schutzgitter 2 beaufschlagt. Durch eine geeignete Einstellung der Amplitude und der Phase der Wechselspannung W2 kann die Empfindlichkeit des Fingerabdrucksensors 1 optimiert werden.

Fig. 1B zeigt schematische Diagramme der Wechselspannungen W1 und W2 in Abhängigkeit von der Zeit t. In Fig. 1B sind die Wechselspannungen W1 und W2 durch Rechteckimpulse charakterisiert. Dabei stimmen bei den Wechselspannungen W1 und W2 die Zeitlängen der Impulse und die Zeitabstände zwischen aufeinanderfolgenden Impulsen überein, d.h. die Wechselspannungen W1 und W2 weisen die gleichen Frequenzen auf. Jedoch unterscheiden sich die Wechselspannungen W1 und W2 in den Amplituden und den Phasen der Impulse.

**Patentansprüche**

1.  Fingerabdrucksensor (1) mit

    - einer Mehrzahl von Sensorelektroden, welche unterhalb einer für den Kontakt mit einer Fingerunterseite bestimmten Kontaktoberfläche des Fingerabdrucksensors (1) angebracht sind und welche zum Aufnehmen des Fingerabdrucks dienen, und
    - mindestens einer ESD-Schutzelektrode (2), welche auf oder in der Kontaktoberfläche angebracht ist und welche die Sensorelektroden zumindest nicht vollständig abdeckt, wobei
    - die Sensorelektroden mit einer ersten Wechselspannung (W1), die eine vorgegebene Frequenz aufweist, beaufschlagbar sind, wobei
    - die mindestens eine ESD-Schutzelektrode (2) mit einer zweiten Wechselspannung (W2), die die vorgegebene Frequenz aufweist, beaufschlagbar ist,

    **dadurch gekennzeichnet,**

    - **daß** die Amplitude der zweiten Wechselspannung (W2) größer als die versorgungsspannung des Fingerabdrucksensors (1) ist.

2.  Fingerabdrucksensor (1) nach Anspruch 1,
    **dadurch gekennzeichnet,**

    - **daß** die Phase der ersten Wechselspannung (W1) und die Phase der zweiten Wechselspannung (W2) einstellbar sind.

3.  Fingerabdrucksensor (1) nach Anspruch 1 oder 2,
    **dadurch gekennzeichnet,**

    - **daß** die mindestens eine ESD-Schutzelektrode (2) als gitter- oder rechen- oder streifenähnliche Fläche ausgebildet ist.

4.  Fingerabdrucksensor (1) nach Anspruch 1 oder 2,
    **dadurch gekennzeichnet,**

    - **daß** die Amplitude der ersten Wechselspannung (W1) und die Amplitude der zweiten Wechselspannung (W2) einstellbar sind.

5.  Fingerabdrucksensor (1) nach Anspruch 4,
    **dadurch gekennzeichnet,**

    - **daß** die Amplitude der zweiten Wechselspannung (W2) größer als die Amplitude der ersten Wechselspannung (W1) ist.

6.  Verfahren zur Optimierung der Empfindlichkeit eines Fingerabdrucksensors (1) nach einem oder mehreren der vorhergehenden Ansprüche, bei welchem die Amplitude und/oder die Phase der zweiten Wechselspannung (W2) derart eingestellt wird, daß die Empfindlichkeit des Fingerabdrucksensors (1) einen maximalen Wert annimmt, und die Empfindlichkeit durch das lokale Auflösungsvermögen des Fingerabdrucksensors bestimmt wird.

**Claims**

1. Fingerprint sensor (1) having

   - a plurality of sensor electrodes which are mounted below a contact surface, intended for contact with the underside of a finger, on the fingerprint sensor (1) and are used for recording the fingerprint, and
   - at least one ESD protective electrode (2) which is mounted on or in the contact surface and which covers the sensor electrodes at least incompletely, where
   - the sensor electrodes can have a first AC voltage (W1) at a prescribed frequency applied to them, where
   - the at least one ESD protective electrode (2) can have a second AC voltage (W2) at the prescribed frequency applied to it,

   **characterized**

   - **in that** the amplitude of the second AC voltage (W2) is greater than the supply voltage for the fingerprint sensor (1).

2. Fingerprint sensor (1) according to Claim 1,
   **characterized**

   - **in that** the phase of the first AC voltage (W1) and the phase of the second AC voltage (W2) can be set.

3. Fingerprint sensor (1) according to Claim 1 or 2,
   **characterized**

   - **in that** the at least one ESD protective electrode (2) is in the form of a grating-like or grid-like or strip-like area.

4. Fingerprint sensor (1) according to Claim 1 or 2,
   **characterized**

   - **in that** the amplitude of the first AC voltage (W1) and the amplitude of the second AC voltage (W2) can be set.

5. Fingerprint sensor (1) according to Claim 4,
   **characterized**

   - **in that** the amplitude of the second AC voltage (W2) is greater than the amplitude of the first AC voltage (W1).

6. Method for optimizing the sensitivity of a fingerprint sensor (1) according to one or more of the preceding claims, in which the amplitude and/or the phase of the second AC voltage (W2) is set such that the sensitivity of the fingerprint sensor (1) assumes a maximum value and the sensitivity is determined by the local resolution of the fingerprint sensor.

**Revendications**

1. Capteur (1) d'empreintes digitales comprenant

   - une multiplicité d'électrodes de capteur, qui sont mises en dessous d'une surface de contact du capteur (1) d'empreintes digitales destinées à venir en contact avec la face inférieure du doigt et qui servent à recevoir l'empreinte digitale, et
   - au moins une électrode (2) de protection ESD, qui est mise sur ou dans la surface de contact et qui recouvre au moins non complètement les électrodes de capteur, les électrodes de capteur pouvant être alimentées en une première tension (W1) alternative qui a une fréquence prescrite, dans lequel
   - la au moins une électrode (2) de protection ESD peut être alimentée en une deuxième tension (W2) alternative qui a la fréquence prescrite,

**caractérisé**

- **en ce que** l'amplitude de la deuxième tension (W2) alternative est plus grande que la tension d'alimentation du capteur (1) d'empreintes digitales.

2. Capteur (1) d'empreintes digitales suivant la revendication 1,
**caractérisé**

- **en ce que** la phase de la première tension (W1) alternative et la phase de la deuxième tension (W2) alternative peuvent être réglées.

3. Capteur (1) d'empreintes digitales suivant la revendication 1 ou 2,
**caractérisé**

- **en ce que** la au moins une électrode (2) de protection ESD est constituée sous la forme d'une surface analogue à une grille, à un râteau ou à une bande.

4. Capteur (1) d'empreintes digitales suivant la revendication 1 ou 2,
**caractérisé**

- **en ce que** l'amplitude de la première tension (W1) alternative et l'amplitude de la deuxième tension (W2) alternative peuvent être réglées.

5. Capteur (1) d'empreintes digitales suivant la revendication 4,
**caractérisé**

- **en ce que** l'amplitude de la deuxième tension (W2) alternative est plus grande que l'amplitude de la première tension (W1) alternative.

6. Procédé d'optimisation de la sensibilité d'un capteur (1) d'empreintes digitales suivant l'une ou plusieurs des revendications précédentes, dans lequel on règle l'amplitude et/ou la phase de la deuxième tension (W2) alternative de façon à ce que la sensibilité du capteur (1) d'empreintes digitales prenne une valeur maximum et l'on détermine la sensibilité par le pouvoir de résolution local du capteur d'empreintes digitales.

Fig. 1A

Fig. 1B